(19) Europäisches Patentamt

European Patent Office

Office européen des brevets

(11) **EP 2 348 388 B1**

(12) **EUROPEAN PATENT SPECIFICATION**

(45) Date of publication and mention
of the grant of the patent:
**19.06.2019 Bulletin 2019/25**

(51) Int Cl.:
***H04N 13/373*** *(2018.01)*      ***H04N 13/383*** *(2018.01)*

(21) Application number: **11151164.8**

(22) Date of filing: **17.01.2011**

(54) **Image display device having imaging device**

Bildanzeigevorrichtung mit einer Abbildungsvorrichtung

Dispositif d'affichage d'images doté d'un dispositif d'imagerie

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.01.2010 JP 2010012052
22.01.2010 JP 2010012051**

(43) Date of publication of application:
**27.07.2011 Bulletin 2011/30**

(73) Proprietor: **JOLED INC.
Tokyo 101-0054 (JP)**

(72) Inventors:
• **Nakamura, Kazuo
Minato-ku Tokyo 108-0075 (JP)**
• **Uchino, Katsuhide
Minato-ku Tokyo 108-0075 (JP)**

(74) Representative: **D Young & Co LLP
120 Holborn
London EC1N 2DY (GB)**

(56) References cited:
**GB-A- 2 324 428       JP-A- 2000 341 591
US-A1- 2008 106 629   US-B1- 6 454 414**

• **HIROSHI HARASHIMA ET AL: "INTELLIGENT
IMAGE CODING AND COMMUNICATIONS WITH
REALISTIC SENSATIONS - RECENT TRENDS -",
IEICE TRANSACTIONS, INSTITUTE OF
ELECTRONICS INFORMATION AND COMM. ENG.
TOKYO, JP, vol. E74, no. 6, 6 June 1991
(1991-06-06), pages 1582-1592, XP000262316,
ISSN: 0917-1673**

**Description**

The present invention relates to an image display device having an imaging device. In recent years, as a flat panel display device (FP display panel), an organic electroluminescence display device (hereinafter sometimes simply referred to as "organic EL display device") is getting popular. At present, although a liquid crystal display device (LDC) is the mainstream of the FP display device, it is not a self-luminous device and requires members such as a backlight and a polarizing plate. Therefore, there are problems that the thickness of the FP display device increases, and the luminance becomes insufficient. On the other hand, the organic EL display device is the self-luminous device, and members such as a backlight are not required in principle, and as compared with the LCD, there are many merits such as reduction in thickness and high luminance. Especially, in an active matrix organic EL display device including a switching device in each pixel, power consumption can be suppressed to be low by holding and turning on each pixel. Further, an increase in size of a screen and an improvement in fineness can be relatively easily performed. Thus, the active matrix organic EL display device is developed in many companies, and is expected to become the mainstream of a next generation FP display device.

An attempt to add a function other than image display to an image display device is actively performed. For example, an image display device to which a function of a pointing device is added by providing a so-called pressure-sensitive sensor on an image display surface of the image display device is widely known. Besides, JP-A-2005-176151 or JP-A-2005-010407 discloses an FP display device having an imaging device.

Besides, in recent years, a so-called three-dimensional image display device is also developed. The three-dimensional image display system is roughly classified into a system using an attached equipment such as glasses and a naked eye three-dimensional image display system not using an attached equipment. The naked eye three-dimensional image display system includes two systems, that is, a parallax barrier system in which a parallax barrier is used to present parallax images to the right and left eyes of an observer and to cause the observer to perceive a three-dimensional image, and a lenticular system in which a semicylindrical lens (lenticular lens) is attached to an image display surface of an image display device to perform three-dimensional image display.

Further, in recent years, a video teleconference system (television telephone apparatus) starts to become popular in which at least two pairs of image display devices and imaging devices are used, and these are connected to each other through a communication line or a network, so that a conversation is made between people at remote locations while looking at each other. The TV telephone function can be easily realized by using an inexpensive imaging device called a web camera, a personal computer and software.

In an image display device to which a function of a pointing device is added, it is necessary to provide a pressure sensitive sensor. Thus, there is a problem that the manufacturing cost of the image display device rises, and there is also a problem that since an image is seen through the pressure sensitive sensor, the quality of the image displayed by the image display device is reduced.

In the technique disclosed in JP-A-2005-176151, plural openings each including a microlens are provided between pixels constituting an image display part of an image display device, and plural cameras take images of light passing through the plural openings. Here, images of the face of a user who sees the image display device are taken from plural different angles, and the plural obtained images are processed to create an image obtained when the user is viewed from the front. However, in the technique disclosed in this patent publication, it is necessary to provide the microlens in the opening, and further, in order to accurately focus the image on the imaging device, the high-accuracy microlens is required. Thus, the manufacturing cost of the image display device increases. Further, the image of the front face of the user is not taken, but the front image is formed from plural images taken from the different angles. Thus, the image is not an actual image, and the so-called CG image is provided to the partner side, and accordingly, in fact, uncomfortable feeling is large.

In the technique disclosed in JP-A-2005-010407, for example, as shown in FIG. 15 and FIG. 16 thereof, since the imaging device takes an image based on light passing through one light transmission part provided for plural pixels, it is difficult to condense a sufficient amount of light to the imaging device.

Other prior art includes US -A-2008/0106629 and US 6,454,414 disclosing displays with a camera arranged on the back side of the display panel, JP-A-2000/341591 disclosing a partially transparent display panel, and GB 2324428.

Accordingly, it is desirable to provide an image display device having an imaging device in which in addition to a function of a pointing device, a function to acquire information relating to a position and the like of an observer can be added, and which can be manufactured at low cost and can condense a sufficient amount of light to the imaging device.

According to an embodiment of the present invention, there is provided an image display device having an imaging device according to Claim 1.

The image display device having the imaging device of the embodiment of the invention includes the position detecting means for obtaining the position information of the subject based on the image information acquired through the imaging device. Here, when the position detecting means continuously obtains the position information of the subject (for example, hand, finger, eyeball, etc.) in time series, the movement of the subject (for example, hand, finger, eyeball, line of sight) can be obtained, and various processes corresponding to the position and the movement of the subject (for example, hand, finger, eyeball, line of sight) can be performed. Alternatively, when the position detecting means obtains the direction in which the subject is directed, various processes corresponding to the direction in which the subject is directed can be performed. Besides, since a corresponding indication point on the image display part can be specified from the direction of the hand, pen or the like, the so-called pointer function can be added to the image display device having the imaging device. Further, since the imaging device is arranged on the back side of the image display part, as compared with a case where the imaging device is arranged at a place other than the back of the screen, the image of the subject can be taken more accurately, and the image of the face, eye, motion or the like of the user facing the image display part can be accurately taken by the imaging device. By this, the position information of the subject can also be accurately obtained, and the high-performance detection function for position information can be provided. Besides, in a three-dimensional image, based on the position information, an optimum three-dimensional image observation position can be indicated to the observer, or the observer can be guided to the optimum three-dimensional image observation position, or the optimum three-dimensional image can be provided according to the position of the observer.

The invention relates to an image display device in which an imaging device is arranged on the back side of an image display part.

Various respective aspects and features of the invention are defined in the appended claims. Combinations of features from the dependent claims may be combined with features of the independent claims as appropriate and not merely as explicitly set out in the claims.

Embodiments of the invention will now be described with reference to the accompanying drawings, throughout which like parts are referred to by like references, and in which:

FIG. 1A and FIG. 1B are schematic views of an image display device having an imaging device of an embodiment 1 when viewed from front and from side, and FIG. 1C is a view schematically showing the arrangement of plural pixels constituting an image display part.

FIG. 2 is a schematic partial sectional view of an image display device having an imaging device of an embodiment.

FIG. 3A and FIG. 3B are conceptual views of the image display device having the imaging device of the embodiment 1 and an image display device in which an imaging device is fixed to the outside of an image display part.

FIG. 4A and FIG. 4B are schematic views of a three-dimensional image display device having an imaging device when viewed from front and from side, and FIG. 4C is a view schematically showing the arrangement of plural pixels constituting an image display part.

FIG. 5 is a conceptual view for explaining a method of obtaining, in the image display device having the imaging device of the embodiment 1, a distance (D) from an imaging device to an observer and a distance (R) between pupils of the observer.

FIG. 6 is a schematic view for explaining a diffraction phenomenon caused by a slit.

FIG. 7A and FIG. 7B show an image obtained by photographing through a transparent glass plate disposed in front of an imaging device, and an image obtained by photographing through a transparent glass plate which is disposed in front of an imaging device and is provided with a light transmission region which is an aggregation of light transmission parts having shapes, sizes and distribution.

FIG. 8 is a block diagram of an image display device having an imaging device of an embodiment 2.

FIG. 9A and FIG. 9B are views schematically showing shapes of light transmission parts constituting a light transmission region in the embodiment 2.

FIG. 10 is a view schematically showing another shape of the light transmission parts constituting the light transmission region in the embodiment 2.

FIG. 11 is a block diagram of an image display device having an imaging device of an embodiment 3.

FIG. 12A and FIG. 12B are views schematically showing shapes of light transmission parts constituting a light transmission region in an embodiment 4.

FIG. 13A and FIG. 13B are schematic views of a notebook-size personal computer and a cellular phone.

Hereinafter, embodiments of the invention will be described with reference to the drawings. However, the invention is not limited to the embodiments, and various numerical values and materials in the embodiments are exemplary only. Incidentally, the description will be made in the following sequence.

1. General description of an image display device having an imaging device according to a first mode and a second mode of the invention

2. Embodiment 1 (the image display device having the imaging device according to the first mode of the invention)

3. Embodiment 2 (modification of the embodiment 1, first configuration of the invention)

4. Embodiment 3 (modification of the embodiment 2, second configuration of the invention)

5. Embodiment 4 (the image display device having the imaging device according to the second mode of the invention), and the others

[General description of an image display device having an imaging device according to the invention]

In the image display device having the imaging device according to the invention, a configuration can be made such that a light transmission region is provided for plural pixels. Incidentally, for convenience, the image display device having the imaging device according to the invention having the configuration as stated above is called "the image display device having the imaging device according to a first mode of the invention". Alternatively, a configuration can be made such that a light transmission region is provided around at least one (preferably, at least two) pixel. In this case, the light transmission region may be provided around the entire periphery of the pixel or may be provided in a part of the periphery of the pixel (specifically, two or more continuous sides among sides corresponding to the boundary of the pixel) . In the latter case, it is preferable that the light transmission region is provided over the length of 1/4 or more of the entire periphery of the pixel (in the two continuous sides, 1/2 or more of the length of each of the sides). Incidentally, for convenience, the image display device having the imaging device according to the invention having the configuration as stated above is called "the image display device having the imaging device according to a second mode of the invention". In the image display device having the imaging device according to the first mode or the second mode of the invention, light passing through the light transmission region provided for the plural pixels is condensed to the imaging device, or light passing through the light transmission region provided around at least one pixel is condensed to the imaging device. Accordingly, a highly accurate microlens is not required to accurately focus an image on the imaging device, the manufacturing cost of the image display device having the imaging device is not increased, and a sufficient amount of light can be condensed to the imaging device.

In the image display device having the imaging device according to the invention including the image display device having the imaging device according to the first mode or the second mode of the invention (hereinafter, these are sometimes generically called simply "the image display device having the imaging device according to the invention"), the light transmission region includes plural light transmission parts. When each of the light transmission parts is provided for the pixel, the diffraction phenomenon occurs in the light transmission part constituting the light transmission region, and consequently, there is a case where an image focused on the imaging device is blurred, or the sharpness is lost. In such a case, with respect to image information acquired through the imaging device, or other image data (for example, image data obtained by photographing the user or the like by the imaging device and to be displayed on an image display part, and such other image data is sometimes simply called "image data") acquired through the imaging device and to be displayed on the image display part, it is preferable to adopt a configuration further including a diffraction correcting section configured to correct diffraction generated in the light transmission part constituting the light transmission region. Incidentally, for convenience, the configuration as stated above is called "first configuration of the invention".

In the first configuration of the invention, a part or all of the light transmission parts constituting the light transmission region are periodically provided in a first direction and a second direction of the image display part. When the length of the light transmission part in the first direction is Ltr-1, and the pixel pitch in the first direction is Ppx-1, it is preferable that a line aperture ratio LTr-1/Ppx-1 in the first direction satisfies LTr-1/Ppx-1$\geq$0.5, and preferably satisfies LTr-1/Ppx-1 $\geq$ 0.8.

Further, when the length of the light transmission part in the second direction is Ltr-2, and the pixel pitch in the second direction is Ppx-2, it is preferable that a line aperture ratio Ltr-2/Ppx-2 in the second direction satisfies Ltr-2/Ppx-2 $\geq$ 0.5, and preferably satisfies Ltr-2/Ppx-2 $\geq$ 0.8.

Incidentally, the first direction and the second direction may be orthogonal to each other, or may cross each other at an angle other than 90 degrees. In the latter case, there is also a case where a part or all of the light transmission parts are periodically provided in the third direction, the fourth direction ••• in addition to the first direction and the second direction. In such a case, it is preferable that the lengths of the light transmission parts in at least two directions among the directions and the pixel pitches in at least two directions satisfy the above relation (specifically, 0.5 times or more) . The upper limit value of the line aperture ratios Ltr-1/Ppx-1 and Ltr-2/Ppx-2 is not specifically limited as long as the light transmission part can be formed. Here, the length Ltr-1 of the light transmission part in the first direction means the length, per one period, of a segment corresponding to the shape when the light transmission part is projected in the first direction, and the pixel pitch Ppx-1 in the first direction means the length of the pixel per one period in the first direction. Similarly, the length Ltr-2 of the light transmission part in the second direction means the length, per one period, of a segment corresponding to the shape when the light transmission part is projected in the second direction, and the pixel pitch Ppx-2 in the second direction means the length of the pixel per one period in the second direction.

In the first configuration of the invention, specifically, it is preferable that MTF (Modulation Transfer Function) inverse transformation process calculated based on the shape, size and distribution (and further, based on the wavelength of external light according to circumstances) of the light transmission part is performed on the image information or image data. The shape, size and distribution of the light transmission part may be previously stored in the diffraction correcting section. The diffraction correcting section can be made a circuit having, for example, an input/output part and including a CPU and a memory. According to circumstances, the diffraction correcting section can also be constructed of a personal computer provided in the image display device having the imaging device. When the wavelength of the external light is considered, the optimum image can be obtained independently of the external light (external illumination environment).

In the image display device having the imaging device according to the invention including the above preferable configuration, a configuration can be made such that a wavelength distribution measuring section configured to measure the wavelength distribution of external light is further included. Incidentally, for convenience, the configuration as stated above is called "second configuration of the invention". By adopting the configuration as stated above, improvement in accuracy of the image information and image data obtained through the imaging device (for example, improvement in accuracy of color information) can be realized, and improvement in accuracy of the MTF inverse transformation process can be realized. The wavelength distribution measuring section can be constructed of, for example, a light receiving apparatus such as a photosensor. The control of the wavelength distribution measuring section may be performed by the image display device having the imaging device, and according to circumstances, the control can also be performed by the personal computer provided in the image display device having the imaging device.

In the image display device having the imaging device according to the invention including various preferable configurations, it is desirable that a light-emitting device is a self-luminous light-emitting device, and is more preferably an organic electroluminescence device (organic EL device). Incidentally, a liquid crystal display device constituting a liquid crystal display device is for controlling passing of light from the outside (light from the backlight or external light), and a pixel does not include a light-emitting device. When the light-emitting device is the organic EL device, an organic layer (light-emitting part) constituting the organic EL device includes a light-emitting layer made of an organic light-emitting material, and specifically has, for example, a laminate structure including a hole transport layer, a light-emitting layer and an electron transport layer, a laminate structure including a hole transport layer and a light-emitting layer serving as an electron transport layer, or a laminate structure including a hole injection layer, a hole transport layer, a light-emitting layer, an electron transport layer and an electron injection layer. Besides, when an electron transport layer, a light-emitting layer, a hole transport layer and a hole injection layer are made "a tandem unit", the organic layer may have a two-stage tandem structure in which a first tandem unit, a connection layer and a second tandem unit are laminated, and further, may have a three or more tandem structure in which three or more tandem units are laminated. In these cases, when the light-emitting color is changed to red, green and blue in the respective tandem units, an organic layer to emit white light as a whole can be obtained.

By optimizing the thickness of the organic layer, for example, a configuration can be made such that light emitted in a light-emitting layer between a first electrode and a second electrode is resonated, and a part of the light is emitted to the outside through the second electrode.

Further, in the image display device having the imaging device according to the invention including the various configurations and modes as described above, the image display part includes (a) a first substrate, (b) a drive circuit provided on the first substrate, (c) an interlayer insulating film to cover the drive circuit, (d) a light-emitting part provided on the interlayer insulating layer, (e) a protection layer provided on the light-emitting part, (f) a light-shielding layer provided on the protection layer, and (g) a second substrate to cover the protection layer and the light-shielding layer. Each of pixels includes the drive circuit and the light-emitting part. The light-shielding layer is provided with an opening. A light transmission part constituting a light transmission region includes the opening, a portion of the protection layer positioned below the opening, and a portion of the interlayer insulating layer. A light condensing section and an imaging device are arranged on the side of a surface of the first substrate not facing the second substrate. The light generated in the light-emitting part is emitted to the outside through the protection layer and the second substrate. The light transmission part is provided for the pixel.

Here, as pixel arrangements, for example, a stripe arrangement, a diagonal arrangement, a delta arrangement, and a rectangle arrangement can be mentioned. Besides, as the first substrate or the second substrate, a high-distortion glass substrate, a soda glass ($Na_2O \cdot CaO \cdot SiO_2$) substrate, a borosilicate glass ($Na_2O \cdot B_2O_3 \cdot SiO_2$) substrate, a forsterite ($2MgO \cdot SiO_2$) substrate, a lead glass ($Na_2O \cdot PbO \cdot SiO_2$) substrate, various glass substrates having insulating films formed on the surfaces, a quartz substrate, a quartz substrate having an insulating film formed on the surface, a silicon substrate having an insulating film formed on the surface, an organic polymer (having a form of a polymer material, such as a plastic film, a plastic sheet or a plastic substrate, which is made of a polymer material and has flexibility) exemplified by polymethyl methacrylate (polymethyl methacrylate, PMMA), polyvinyl alcohol (PVA), polyvinyl phenol (PVP), polyether sulfone (PES), polyimide, polycarbonate and polyethylene terephthalate (PET) can be named. The drive circuit may include, for example, one or plural thin film transistors (TFT) . As constituent material of the interlayer insulating layer, $SiO_2$, BPSG, PSG, BSG, AsSG, PbSG, SiON, SOG (Spin On Glass), low melting point glass, $SiO_2$ material such as glass paste, SiN material, and insulating resin such as polyimide can be used separately or in suitable combination. In the case where the pixel includes an organic EL device, the light-emitting part is as described above. As the material constituting the protection film, it is preferable to use a material which is transparent to light emitted by the light-emitting part, is dense, and is not permeable to water. Specifically, for example, amorphous silicon ($\alpha$-Si), amorphous silicon

carbide (α-SiC), amorphous silicon nitride (α-Si1-xNx), amorphous silicon oxide (α-Si1-yOy), amorphous carbon (α-C), amorphous oxide•nitride silicon (α-SiON) and Al2O3 can be mentioned. The light-shielding film (black matrix) may be made of a well-known material. A color filter may be provided as the need arises.

In the image display device having the imaging device according to the invention including the various preferable configurations and modes (hereinafter sometimes simply generically referred to as "the invention"), for example, a hand, a finger or an eyeball of an observer (user) who observes the image display part, a rod-like material grasped by the hand of the user and the like can be named as a subject. When a position detecting section continuously obtains the position information of the subject (for example, hand or finger, eyeball, rod-like material (for example, pen, pencil, etc.)) in time series, the movement of the subject can be obtained, and various processes (processes such as, for example, up and down or right and left movement of an image on the monitor of a personal computer, process of closing a screen, and process of opening another screen) can be performed. Incidentally, the relation between the movement of the subject and various processes may be registered in the position detecting section. Alternatively, when the position detecting section obtains the direction in which the subject is directed, various processes corresponding to the direction in which the subject is directed can be performed. Besides, since the corresponding indication point on the image display part can be specified by the direction of the hand, pen or the like, the pointer function can be added to the image display device having the imaging device. The position detecting section can be made a circuit having an input/output section and including a CPU and a memory. According to circumstances, the position detecting section can also be constructed of a personal computer provided in the image display device having the imaging device. A signal (data) obtained by the imaging device is sent to the position detecting section, and is processed in the position detecting section. Such process may be performed by a well-known method (well-known algorism or software). At the execution of various processes, the confirmation of the execution of various processes may be displayed on the image display part or may be requested by sound. Incidentally, as compared with a case where an imaging device is provided at a position other than the screen back, when the imaging device provided on the screen back takes an image of a subject, with respect to the position information and movement information of the subject in a plane direction (up and down or right and left direction) relative to the screen, more accurate position information can be obtained.

In the invention, the image display part includes plural pixel units including light-emitting devices. When the number of pixel units is denoted by (M, N), although some image display resolutions, such as VGA (640, 480), S-VGA (800, 600), XGA (1024, 768), APRC (1152, 900), S-XGA (1280, 1024), U-XGA (1600, 1200), HD-TV (1920, 1080) and Q-XGA (2048, 1536), as well as (1920, 1035), (720, 480), (854, 480) and (1280, 960), can be exemplified, no limitation is made to these values. Incidentally, in the image display part to perform color display, one pixel unit includes, for example, three kinds of pixels, that is, a red light-emitting pixel to emit red light, a green light-emitting pixel to emit green light, and a blue light-emitting pixel to emit blue light. Alternatively, one pixel unit can include four or more kinds pixels, such as, in addition to these three kinds of pixels, a pixel to emit white light for improving luminance, a pixel to emit complementary color light for expanding a color reproduction range, a pixel to emit yellow light for expanding the color reproduction range, and a pixel to emit yellow and cyan light for expanding the color reproduction range.

In the image display device having the imaging device of the first mode of the invention, the light transmission region is provided for the plural pixels. Here, specifically, although no limitation is intended, it is desirable that the light transmission region is provided for, for example, three or more pixels. The outer shape of the light transmission part constituting the light transmission region is essentially arbitrary, and a quadrangle, such as a rectangle or a square, can be mentioned. In the image display device having the imaging device of the second mode of the invention, the light transmission region is provided around at least one pixel. Here, specifically, although no limitation is intended, it is desirable that the light transmission region is provided around, for example, three or more pixels. The outer shape of the light transmission region is essentially arbitrary, and an "L" shape (form in which the light transmission region is provided on two continuous sides among sides corresponding to the boundary of the pixel), a "C" shape (form in which the light transmission region is provided on three continuous sides among sides corresponding to the boundary of the pixel), a "□" shape (form in which the light transmission region is provided on all sides corresponding to the boundary of the pixel), and a curb shape (form in which the light transmission region is provided on all sides corresponding to the boundary of the pixel and is commonly provided between the adjacent pixels) can be mentioned. Alternatively, it is preferable that the light transmission region is provided for a pixel group including a projection image of a lens provided in the imaging device or is provided around the pixel group.

In the invention, although it is sufficient if the imaging device is arranged on the back side of the image display part, it is preferable that the imaging device is arranged at the center of the image display part. By this, the position information of the subject facing the image display part can be accurately obtained in a wider range. The number of imaging devices may be one or plural. The imaging device may be a commercially available solid imaging device including a CCD device or a CMOS sensor. Incidentally, the solid imaging device such as a well-known commercially available video camera or web camera can also be used, and in these cases, the light condensing section and the imaging device are integrated.

As the light condensing section configured to condense light passing through the light transmission region to the imaging device, a well-known lens can be mentioned. The lens is, specifically, one of a biconvex lens, a plane-convex lens and a meniscus convex lens, or may be a reflecting mirror or a Fresnel lens, or may be a combination of these various convex lenses, or further may be a combination of a concave lens and these various convex lenses.

In the invention, it is preferable that a color filter is not arranged in a light path of light which is incident on the image display part, passes through the light transmission region, outgoes from the image display part, and is incident on the condensing section. Besides, it is preferable that an imaging system such as a microlens is not arranged.

For example, the invention can be used as a substitution for a monitor device constituting a personal computer, can be used as a substitution for a monitor device assembled in a notebook-size personal computer, or can be used as a substitution for a monitor device assembled in a cellular phone, a PDA (Personal Digital Assistant) or a game equipment or for a related art television receiver.

[Embodiment 1]

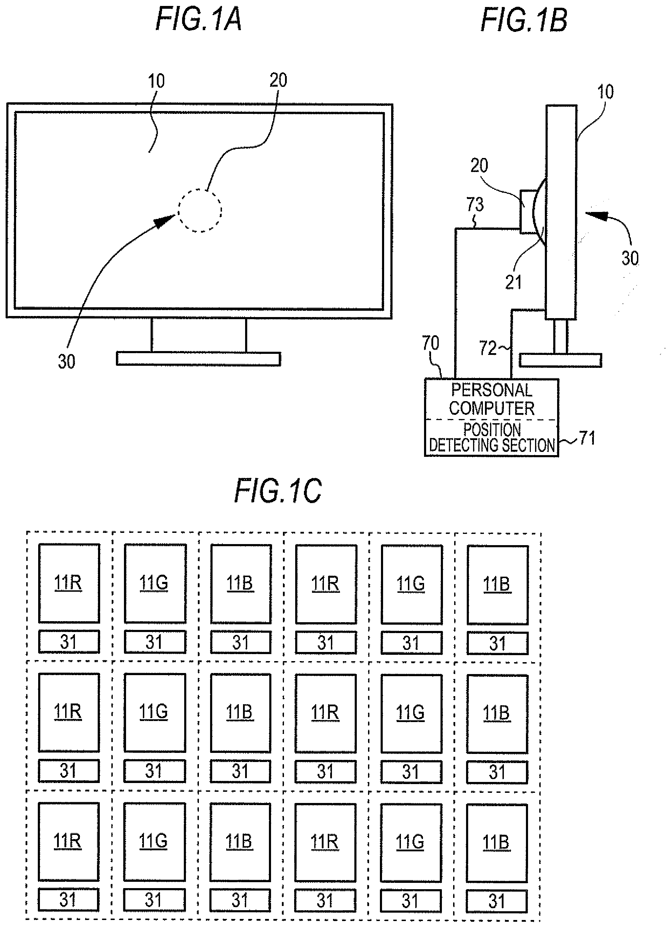

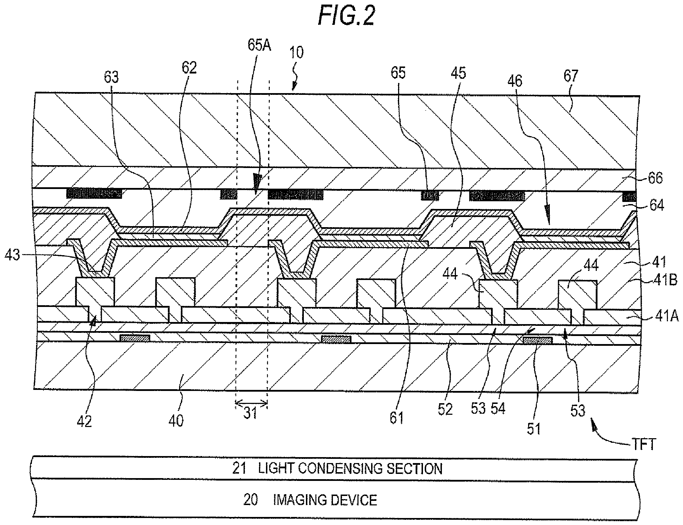

An embodiment 1 relates to the image display device having the imaging device according to the invention, specifically, the image display device having the imaging device according to the first mode of the invention. FIG. 1A and FIG. 1B are conceptual views showing the image display device having the imaging device of the embodiment 1 when viewed from front and from side, and FIG. 1C schematically shows the arrangement of plural pixels constituting an image display part. FIG. 2 is a schematic partial sectional view of the image display device having the imaging device.

The image display device having the imaging device of the embodiment 1 includes (A) an image display part 10 in which plural pixels 11 (11R, 11G, 11B) including light-emitting devices are arranged, (B) a light transmission region 30 provided in the image display part 10, (C) an imaging device 20 arranged on the back side of the image display part 10, (D) a light condensing section 21 configured to condense light passing through the light transmission region 30 to the imaging device 20, and (E) a position detecting section 71 configured to obtain position information of a subject based on image information acquired through the imaging device 20. Here, in the embodiment 1, specifically, the light transmission region 30 is provided for the plural pixels 11. That is, the light transmission region 30 includes an aggregation of light transmission parts 31 provided for the plural pixels 11.

In the embodiment 1 or embodiments 2 to 4 described later, the light-emitting device is a self-luminous light-emitting device, and is specifically an organic EL device. The image display part 10 is a color display XGA-type organic EL display device. That is, when the number of pixel units is denoted by (M, N), it is (1024, 768). Besides, one pixel unit includes a red light-emitting pixel 11R to emit red light, a green light-emitting pixel 11G to emit green light, and a blue light-emitting pixel 11B to emit blue light. Incidentally, in FIG. 1C, FIG. 9A, FIG. 9B, FIG. 10, FIG. 12A and FIG. 12B, the outer edge of a pixel is represented by a dotted line. The imaging device 20 is arranged on the back side of the image display part 10, and is more specifically arranged at the center of the back side of the image display part 10. The number of imaging devices 20 is one. Here, the imaging device 20 and the light condensing section 21 are constructed of a well-known commercially available video camera including a CCD device in which these are integrated. The image display device having the imaging device of the embodiment 1 is used as a substitution for a monitor device constituting a personal computer. Besides, the image display device having the imaging device of the embodiment 1 is provided with a personal computer 70. The personal computer 70 is connected to the image display part 10 and the imaging device 20 through cables 72 and 73.

Although no limitation is intended, the light transmission region 30 is provided for the $6 \times 3 = 18$ pixels 11. One light transmission part 31 is provided for one pixel. The light condensing section 21 condenses the light passing through the light transmission region 30 (specifically, the aggregation of the light transmission parts 31 for the $6 \times 3 = 18$ pixels 11) to the imaging device 20. The shape of the light transmission part 31 provided for each of the pixels 11 is rectangular.

In the embodiment 1 or the embodiments 2 to 4 described later, the image display part 10 is provided with a scan signal supply IC to drive respective scan lines, and a video signal supply IC to supply a video signal. The scan signal supply IC is connected with a scan line control circuit, and the video signal supply IC is connected with a signal line control circuit. A color filter is not arranged in a light path of light which is incident on the image display part 10, passes through the light transmission region 30, outgoes from the image display part 10, and is incident on the light condensing section 21. An imaging system such as a microlens is not also arranged.

In the embodiment 1 or the embodiments 2 to 4 described later, specifically, the image display part 10 includes (a) a first substrate 40, (b) a drive circuit provided on the first substrate 40, (c) an interlayer insulating layer 41 to cover the drive circuit, (d) a light-emitting part (organic layer 63) provided on the interlayer insulating layer 41, (e) a protection layer 64 provided on the light-emitting part (organic layer 63), (f) a light-shielding layer 65 provided on the protection layer 64, and (g) a second substrate 67 to cover the protection layer 64 and the light-shielding layer 65.

Each of the pixels 11 includes the drive circuit and the light-emitting part, and the light-shielding layer 65 is provided with an opening 65A. The light transmission part 31 constituting the light transmission region 30 includes the opening 65A, a portion of the protection layer 64 positioned below the opening 65A, a portion of a second electrode 62, and a portion of the interlayer insulating layer 41. The light condensing section 21 and the imaging device 20 are arranged on the side of a surface of the first substrate 40, which does not face the second substrate 67.

More specifically, the drive circuit is provided on the first substrate 40 made of soda glass. The drive circuit includes plural TFTs. The TFT includes a gate electrode 51 formed on the first substrate 40, a gate insulating film 52 formed on the first substrate 40 and the gate electrode 51, source/drain regions 53 provided in a semiconductor layer formed on the gate insulating film 52, and a channel formation region 54 corresponding to a portion of the semiconductor layer positioned between the source/drain regions 53 and above the gate electrode 51. In the illustrated example, although the TFT is a bottom gate type, it may be a top gate type. The gate electrode 51 of the TFT is connected to a scan line (not shown) . The interlayer insulating layer 41 (41A, 41B) covers the first substrate 40 and the drive circuit. Besides, a first electrode 61 constituting an organic EL device is provided on the interlayer insulating layer 41B made of SiOx, SiNy, polyimide resin or the like. The TFT is electrically connected with the first electrode 61 through a contact plug 42 provided in the interlayer insulating layer 41A, a wiring 43 and a contact plug 44. In the drawing, one TFT is shown for one organic EL device driving part.

An insulating layer 45 which has an opening 46 and in which the first electrode 61 is exposed at the bottom of the opening 46 is formed on the interlayer insulating layer 41. The insulating layer 45 is made of an insulating material which has excellent flatness and has low water absorption in order to prevent deterioration of the organic layer 63 due to water and to keep light emission luminance, and is specifically made of polyimide resin. The organic layer 63 is formed which is provided on a portion of the first electrode 61 exposed at the bottom of the opening 46 and on a portion of the insulating layer 45 surrounding the opening 46, and includes a light-emitting layer made of organic light-emitting material. Although the organic layer 63 has, for example, a laminate structure including a hole transport layer and a light-emitting layer serving as an electron transport layer, one layer is shown in the drawing. The insulating protection layer 64 made of amorphous silicon nitride ($\alpha$-Si1-xNx) is provided on the second electrode 62 by a plasma CVD method in order to prevent water from reaching the organic layer 63. The light-shielding layer 65 made of black polyimide resin is formed on the protection layer 64, and the second substrate 67 made of soda glass is provided on the protection layer 64 and the light-shielding layer 65. The protection layer 64 and the light-shielding layer 65 are bonded to the second substrate 67 by an adhesion layer 66 made of an acryl adhesive agent. The first electrode 61 is used as an anode electrode, and the second electrode 62 is used as a cathode electrode. Specifically, the first electrode 61 is made of a light reflecting material having a thickness of 0.2 $\mu$m to 0.5 $\mu$m and including aluminum (Al), silver (Ag) or alloy of these. The second electrode 62 is made of a transparent conductive material, such as ITO or IZO, having a thickness of 0.1 $\mu$m, or a metal thin film (semi-transparent metal thin film) which has a thickness of about 5 nm, includes silver (Ag) or magnesium (Mg), and allows light to pass through to a certain degree. The second electrode 62 is not patterned and is formed into one sheet. According to circumstances, an electron injection layer (not shown) having a thickness of 0.3 nm and made of LiF may be formed between the organic layer 63 and the second electrode 62.

When the above is summarized, the detailed configuration of the light-emitting device of the embodiment 1 or the embodiments 2 to embodiment 4 described later is as shown in Table 1

Table 1

| Second substrate 67 | soda glass |
| --- | --- |
| Adhesion layer 66 | acryl adhesive agent |
| Light-shielding layer 65 | black polyimide resin |
| Protection layer 64 | SiNx layer (thickness: 5 $\mu$m) |
| Second electrode (cathode electrode) 62 | ITO layer (thickness: 0.1 $\mu$m) or semi-transparent metal thin film |
| Electron injection layer | LiF layer (thickness: 0.3 nm) |
| Organic layer 63 | as described above |
| First electrode (anode electrode) 61 | Al-Nd layer (thickness: 0.2 $\mu$m) |
| Interlayer insulating layer 41 | SiO2 layer |
| TFT | constituting drive circuit |
| First substrate 40 | soda glass |

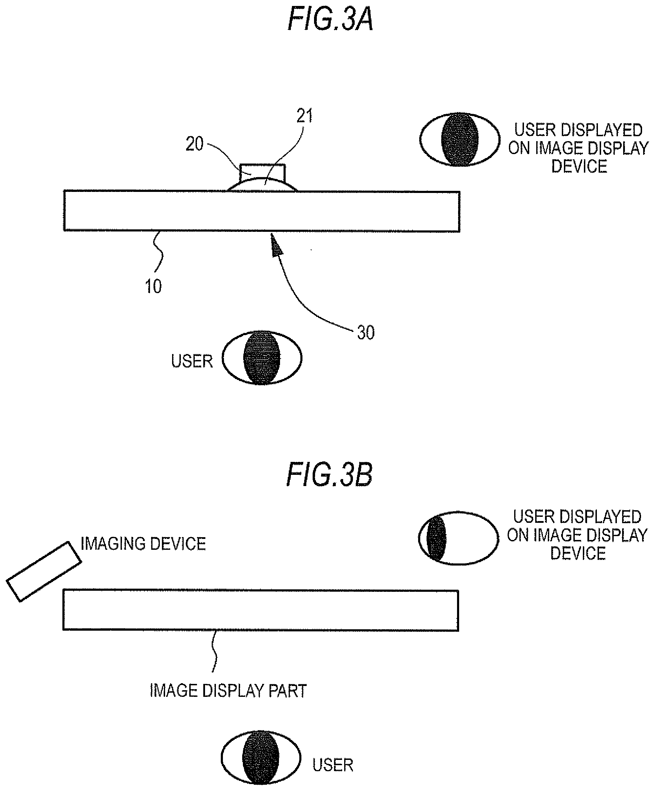

FIG. 3A and FIG. 3B are conceptual views of the image display device having the imaging device of the embodiment 1 and an image display device in which an imaging device is fixed to the outside of an image display part. As shown in FIG. 3B, when the imaging device is fixed to the outside of the image display part, the imaging device obliquely photographs the user of the image display device. When such an image is displayed on the image display part, the image of the user obliquely photographed is displayed on the image display part. Accordingly, the face of the user can not be accurately displayed, and it is also impossible to accurately determine to which part of the image display part the user pays particular attention. Further, when the user approaches the image display part, there is a high possibility that the user is positioned outside the photographing range. On the other hand, in the image display device having the imaging device of the embodiment 1, as shown in FIG. 3A, since the imaging device is arranged at the center of the back side of the image display part, the imaging device can photograph the user of the image display device having the imaging device from the front. When such an image is displayed on the image display part, the image of the user photographed from the front is displayed on the image display part. Accordingly, the face of the user can be accurately displayed, and it is possible to easily and accurately determine to which part of the image display part the user pays particular attention. Besides, even when the user approaches the image display part, the user can be photographed.

The position detecting section 71 includes the personal computer 70 provided in the image display device having the imaging device, and a signal (data) obtained by the imaging device 20 is sent to the position detecting section 71 and is processed by the position detecting section 71. Here, the process is performed based on a well-known method (well-known algorithm or software) . That is, the position information of the subject acquired through the imaging device 20 is obtained by the position detecting section 71, and specifically, the subject is, for example, a hand, a finger, an eyeball or a rod-like material (for example, pen, pencil, etc.). In order to specify the subject, the user may input the name or the like of the subject to the personal computer 70. Alternatively, names or the like of subjects are displayed on the image display part 10, and a subject may be selected. The analysis of the position of the subject acquired through the imaging device 20, the analysis of the movement, and the analysis of the direction in which the subject is directed can be performed based on a well-known algorithm or software provided in the personal computer 70. At the execution of various processes, the confirmation of the execution of various processes may be displayed on the image display part 10 or may be requested by sound. Besides, the relation between the movement of the subject and various processes may be previously registered in the position detecting section 71.

As described above, in the image display device having the imaging device of the embodiment 1, light passing through the light transmission region 30 is condensed by the light condensing section 21 to the imaging device 20, and the position information of the subject is obtained by the position detecting section 71 based on the data acquired through the imaging device 20. Therefore, when the position information of the subject is continuously obtained in time series, the movement of the subject can be obtained, and various processes corresponding to the movement of the subject can be performed. Alternatively, the direction in which the subject is directed can be obtained, and various processes corresponding to the movement of the subject can be performed. Besides, since the corresponding indication point on the image display part can be specified from the direction of the hand or the pen, the pointer function can be added to the image display device having the imaging device. Further, the imaging device 20 is arranged on the back side of the image display part 10, the imaging device 20 can accurately take an image of the subject, and the observer is not conscious of the imaging device 20.

In the image display device having the imaging device of the embodiment 1, light passing through the light transmission region 30 (plural light transmission parts 31) provided in the image display part 10 is condensed to the imaging device 20. Accordingly, a highly accurate microlens is not required to accurately focus an image on the imaging device 20, the manufacturing cost of the image display device having the imaging device is not increased, and a sufficient amount of light can be condensed to the imaging device 20. Further, since the face or the eye of the user, the movement of the hand, the surrounding brightness and the like are also known from the photographed image, various information is obtained from the image display device having the imaging device, and can be sent to various systems, and the additional value of the image display device having the imaging device can be raised.

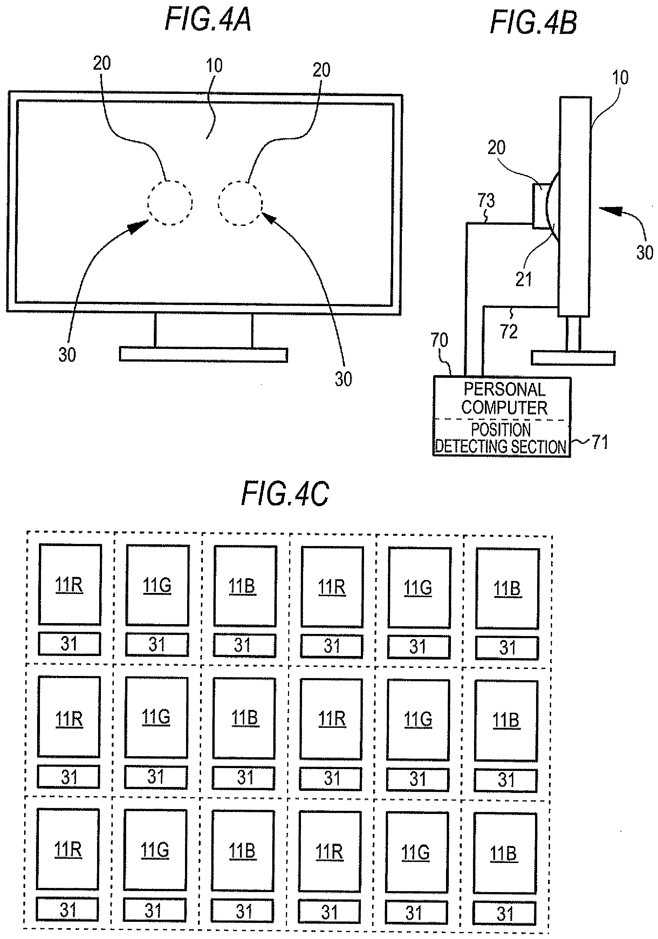

FIGS. 4A to 4C show an embodiment of a case where the invention is applied to a three-dimensional display device. Specifically, plural (more specifically, two) light transmission regions 30, plural imaging devices 20 and plural light condensing sections 21 are provided, each of the light condensing sections 21 condenses the light passing through each of the light transmission regions 30 to each of the imaging devices 20A and 20B. As a display system of a three-dimensional image on the image display part 10, a well-known parallax barrier (parallax) system, a lenticular system and an integral system can be mentioned. In FIGS. 4A 4B, for example, a parallax barrier, a lenticular lens or the like is disposed on or above a second substrate 67 or an image display surface, however, the illustration thereof is omitted.

In the three-dimensional image display system, such as both the parallax barrier system and the lenticular system, using the so-called binocular parallax, the range (space) where the observer can observe a three-dimensional image is limited according to the distance from the image display surface. As a technique to solve this, for example, JP-A-2-044995 discloses an optical direction control method for a three-dimensional image display device. In the technique disclosed in this patent publication, a camera installed outside of the three-dimensional image display device detects the position of both eyes of an observer, and the lenticular lens positioned in front of the three-dimensional image display device is moved in the horizontal direction, so that a stereoscopic vision area is enlarged. However, in such a method, since the observer is conscious of the camera, the line of sight is often directed to the camera instead of the three-dimensional image display device, and the observer is hard to see the three-dimensional image. Besides, it is difficult to accurately control the movement amount of the lenticular lens to the same degree as the pixel pitch in the image display device.

In the image display device having the imaging device according to the invention, the light passing through the light transmission region is condensed by the light condensing section to the imaging device, and the position information of the observer is obtained by the position detecting section based on the image data acquired through the imaging device. Accordingly, when this is applied to the three-dimensional image display device, the optimum three-dimensional image observation position can be indicated to the observer, or the observer can be guided to the optimum three-dimensional image observation position, or the optimum three-dimensional image can be provided according to the position of the observer, so that the observer can easily observe the three-dimensional image without uncomfortable feeling. Further, since the imaging device is arranged on the back side of the image display part, the imaging device can accurately take an image of the face, eye, movement or the like of the user who faces the image display part, and the observer is not conscious of the imaging device.

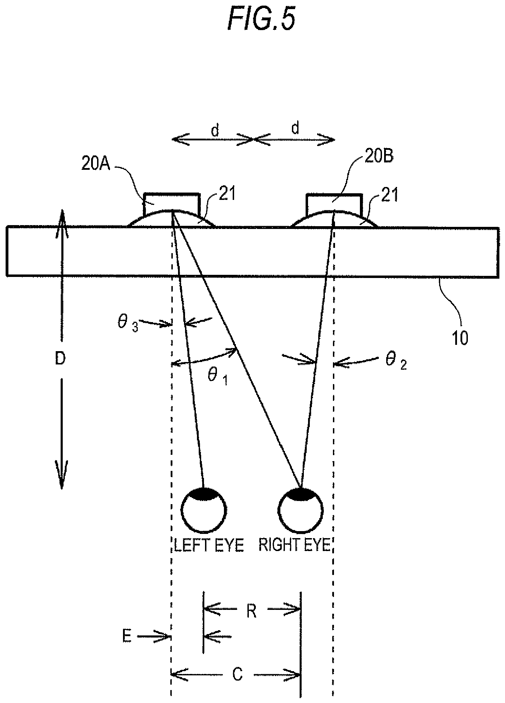

As shown in FIG. 5, it is assumed that the observer is positioned in front of the image display device. Besides, it is assumed that the two imaging devices 20A and 20B are arranged so that each of them is spaced by a distance d in the horizontal direction from the center of the image display device. Then, it is assumed that when the one imaging device 20A photographs, the right eyeball (pupil) of the observer in the image is positioned in the direction of an angle $\theta 1$. Besides, it is assumed that when the other imaging device 20B photographs, the right eyeball (pupil) of the observer in the image is positioned in the direction of an angle $\theta 2$. Then, the distance (viewing distance D) from the imaging device to the observer can be obtained by the following expression (II). Here, "C" is a distance from the one imaging device 20A to the right eyeball in the horizontal direction.

$$\tan(\theta 1) = C/D \qquad (I-1)$$

$$\tan(\theta 2) = (C - 2d)/D \qquad (I-2)$$

The following expression (II) can be deduced from the expression (I-1) and the expression (I-2).

$$D = 2d/\{\tan(\theta 1) - \tan(\theta 2)\} \qquad (II)$$

Incidentally, when the distance (D) from the imaging device to the observer is known, the distance (R) between the pupils of the observer can be calculated. As shown in FIG. 5, it is assumed that when the one imaging device 20A photographs the observer, the right eyeball (pupil) of the observer in the image is positioned in the direction of the angle 91, and the left eyeball (pupil) is positioned in the direction of an angle $\theta 3$. Then, the following expression (I-3) is established. Here, "E" denotes a distance from the one imaging device 20A to the left eyeball in the horizontal direction. Incidentally, the angles $\theta 1$, $\theta 2$ and $\theta 3$ can be obtained by a well-known method from the image obtained by the imaging devices 20A and 20B.

$$\tan(\theta 3) = E/D \qquad (I-3)$$

Accordingly, the following expression (III) is deduced from the expression (I-1), the expression (I-3) and R = C - E. Also from the other imaging device 20B, the distance (R) between the pupils of the observer can be similarly obtained.

$$R = D\{\tan(\theta 1) - \tan(\theta 3)\} \qquad (III)$$

As stated above, in the three-dimensional image display device, the light passing through the light transmission region 30 is condensed to the plural imaging devices 20A and 20B by the light condensing section 21, and the position information of the observer is obtained by the position detecting section 71 based on the image data acquired through the plural imaging devices 20A and 20B. That is, the distance (D) from the imaging device to the observer and the distance (R) between the pupils can be obtained by using the two imaging devices 20A and 20B. Therefore, the observer can be guided to the optimum stereoscopic vision area. Specifically, the position information of the observer is displayed on the image display part, and is displayed on the image display part so that for example, the observer moves right and left, and back and forth. Thus, the optimum three-dimensional image observation position can be clearly indicated to the observer or the observer can be guided to the optimum three-dimensional image observation position, so that the observer can easily observe the three-dimensional image without uncomfortable feeling. Alternatively, based on sound, the optimum three-dimensional image observation position can be clearly indicated to the observer, or the observer can be guided to the optimum three-dimensional observation position. Alternatively, for example, an image is shifted to prevent inverse vision from occurring in the lenticular system or the parallax system, and the display image can be optimized to provide a three-dimensional image without uncomfortable feeling. Further, since the imaging devices 20A and 20B are arranged on the back side of the image display part 10, the imaging devices 20A and 20B can accurately photograph the face, eye, motion and the like of the user who faces the image display part 10, and the observer is not conscious of the imaging devices 20A and 20B. Incidentally, in the embodiment 1, although the description is made on the method of obtaining the position information of the observer based on the distance between the pupils of the observer, the position information may be obtained by detecting a specific part of the observer such as, for example, a mouth, an ear, a hand or the like.

[Embodiment 2]

An embodiment 2 is a modification of the embodiment 1, and relates to the first configuration of the invention. In the embodiment 2, a photographed image is processed in order to obtain a higher quality photographed image.

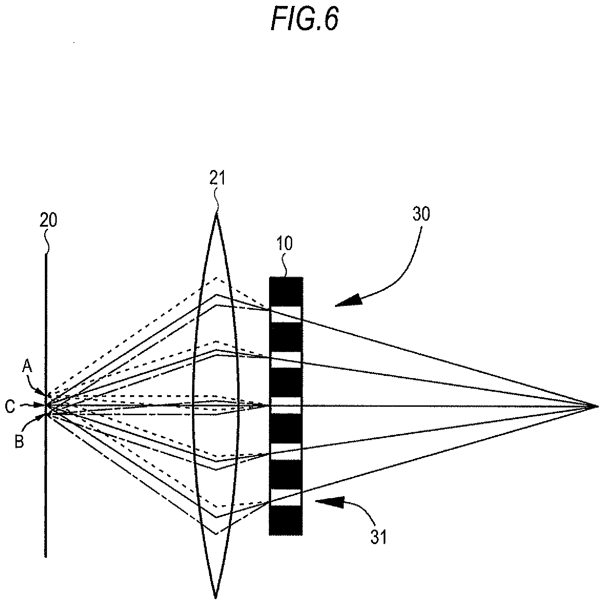

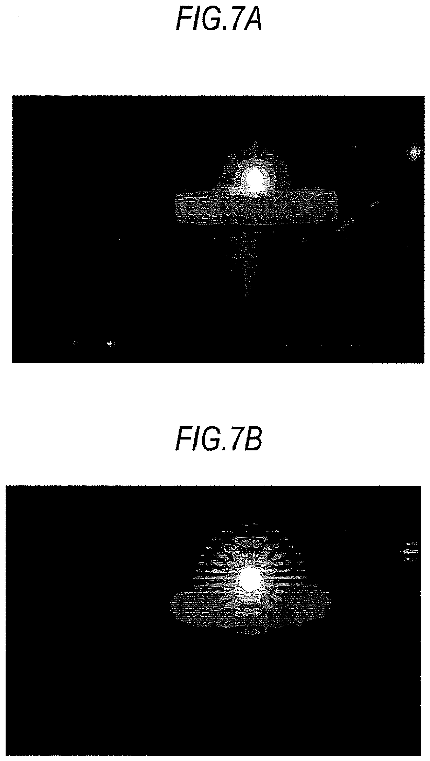

In general, when light passes through a minute light transmission part 31, a so-called diffraction phenomenon occurs in the light transmission part 31. FIG. 6 is a schematic view for explaining the diffraction phenomenon caused by a slit. Here, the light transmission part 31 functions as the slit, and the same image as an image "C" appears as an image "A" and an image "B" at equal pitches by the diffraction phenomenon, and consequently, the image is blurred. FIG. 7A shows an image obtained by photographing after a transparent glass plate is arranged in front of the imaging device 20, and FIG. 7B shows an image obtained by photographing after a transparent glass plate provided with a light transmission part having a certain shape, size and distribution is arranged in front of the imaging device 20. A blur is recognized in the image shown in FIG. 7B. On the other hand, a blur is not recognized in the image shown in FIG. 7A. The intensity and distribution of diffraction light depends on the shape, size and distribution of the light transmission part 31 and the wavelength of incident light (external light). When the blur caused by the diffraction is small, it is not necessary to process a photographed image to correct (compensate) the diffraction. However, when a high quality photographed image is required, it is necessary to correct (compensate) the influence due to the diffraction light.

The image display device having the imaging device of the embodiment 2 further includes a diffraction correcting section 100 configured to correct (compensate) diffraction occurring in the light transmission part 31 on image information and image data acquired through the imaging device 20.

When the pattern shape, size and distribution of the light transmission part 31, and the wavelength of incident light (external light) are determined, a diffraction distribution Pdiff can be calculated by expression (1). Incidentally, in the double integration, the integration is made from $-\infty$ to $+\infty$ with respect to x and y.

$$\text{Pdiff}(kx,ky) = \iint \text{Pat}(x,y) \bullet \exp[-j(kx \bullet x + ky \bullet y)] dxdy \quad (1)$$

where,

$$kx = (2\pi/\lambda)\sin(\theta x)$$

$$ky = (2\pi/\lambda)\sin(\theta y).$$

Here, Pat(x,y) denotes a two-dimensional pattern on a xy plane of the light transmission part 31, $\lambda$ denotes a wavelength of incident light (external light), and $\theta x$ and $\theta y$ denote diffraction angles in the x direction and the y direction. In the embodiment 2, for simplifying the calculation, it is assumed that the value of the wavelength $\lambda$ of the incident light (external light) is made 525 nm and constant.

Since the expression (1) is a two-dimensional Fourier transform of Pat(x,y), it can be calculated at high speed by using fast Fourier transform (hereinafter abbreviated to "FFT"). Incidentally, although Pdiff(kx,ky) includes phase information, the imaging device actually detects diffracted light intensity Hdiff (kx, ky). The diffracted light intensity Hdiff(kx,ky) is equal to the square of the absolute value of Pdiff(kx, ky).

$$Hdiff(kx,ky) = \left| Pdiff(kx,ky) \right|^2 \qquad (2)$$

Here, it is assumed that modulation is added to the space resolution of the imaging device by the diffracted light, and MTF (Modulation Transfer Function) is calculated from the following expression (3). Incidentally, FFT[] means to perform fast Fourier transform, and IFFT[] means to perform fast inverse Fourier transform.

$$MTF(fx,fy) = \left| FFT[Hdiff(kx,ky)] \right|^2 \qquad (3)$$

Where, fx and fy denotes space frequencies in the x direction and the y direction in the respective imaging devices constituting the imaging device. The following relation is established between an image Icam(x,y) on the imaging device 20 obtained through the light transmission part 31 and an original image Iral(x,y) obtained not through the light transmission part 31.

$$FFT[Icam(x,y)] = FFT[Iral(x,y)] \times MTF(fx,fy) \qquad (4)$$

That is, in the space-frequency region, the image Icam(x,y) is the product of the original image Iral(x,y) and MFT. Thus, in order to obtain the original image Iral(x,y) from the image Icam(x,y), the process based on the following expression (5) has only to be performed. In other words, the MTF inverse transform process calculated based on the shape, size and distribution of the light transmission part 31, and the wavelength of incident light (external light) has only to be performed on the image information and image data.

$$Iral(x,y) = IFFT[FFT[Icam(x,y)]/MTF(fx,fy) \qquad (5)$$

Where, when the size, shape and distribution of the light transmission part 31 are determined, the MTF can be easily obtained by scaling the two-dimensional pattern, subjected to Fourier transform, of the light transmission part 31 by the wavelength of incident light (external light), and the original image can be easily restored from the relation indicated by the expression (5).

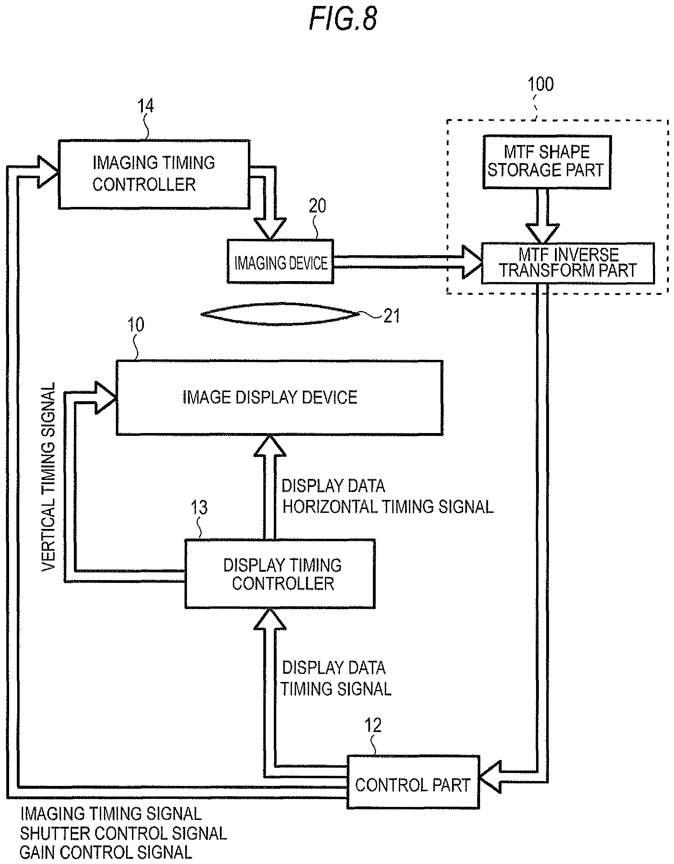

FIG. 8 is a block diagram of the image display device having the imaging device of the embodiment 2. The image information and image data acquired through the imaging device 20 is sent to an MTF inverse transform part constituting the diffraction correcting section 100. The MTF inverse transform part performs MFT inverse transform by using the wavelength of external light of each of red (R), green (G) and blue (B) (in the embodiment 2, for simplification of calculation, one kind of wavelength) and MTF shape data of the light transmission part 31 obtained by two-dimensional FFT, and the original image is restored and is sent to a control part 12. The control part 12 performs various detections, such as detection of the line of sight of the user, and detection of the subject of user's hand movement. Besides, the position information of the subject, the movement of the subject, and the direction of the subject are obtained by the position detecting section 71, and are reflected on the display image part. Incidentally, the control section 12 serves also as the position detecting section 71. The MTF shape data, such as size, shape and distribution, of the light transmission part 31 is stored in an MTF shape storage section constituting the diffraction correcting section 100. The control part 12 is provided in the image display device (or image display part) having the imaging device or is constructed of the personal computer 70 provided in the image display device having the imaging device. The diffraction correcting section 100 is also provided in the image display device (or image display part) having the imaging device, or is constructed of the personal computer 70 provided in the image display device having the imaging device.

The image display in the image display part 10 is performed by control of the control section 12. That is, the control section 12 sends display data, a timing signal and the like to a display timing controller 13. The display timing controller 13 sends the display data and a horizontal timing signal to a signal line control circuit (not shown), and sends a vertical timing signal to a scan line control circuit (not shown). In the image display part 10, the image display is performed by a well-known method. On the other hand, the control section 12 sends a photographing timing signal, a shutter control signal, a gain control signal and the like to an imaging timing controller 14. The imaging timing controller 14 sends these signals to the imaging device 20, and the operation of the imaging device 20 is controlled.

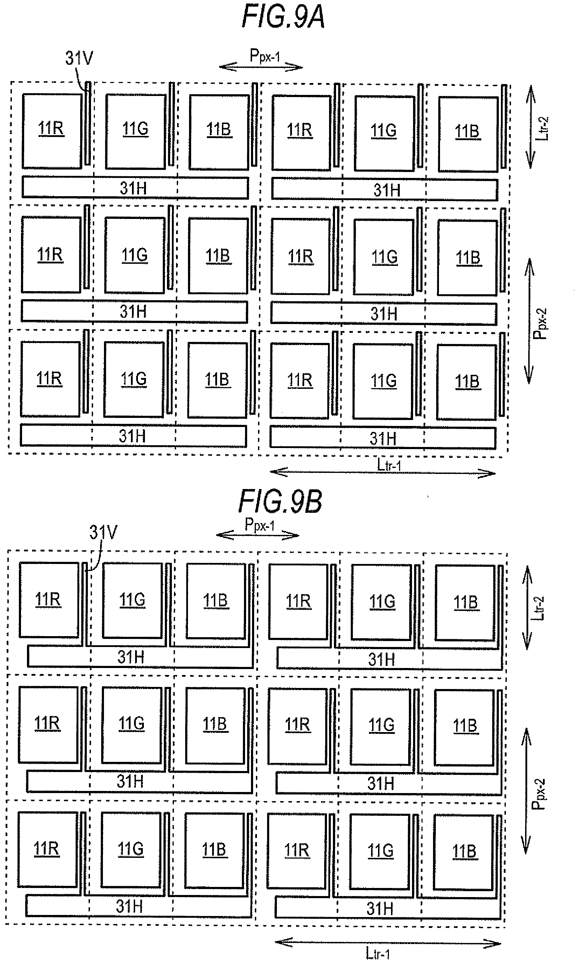

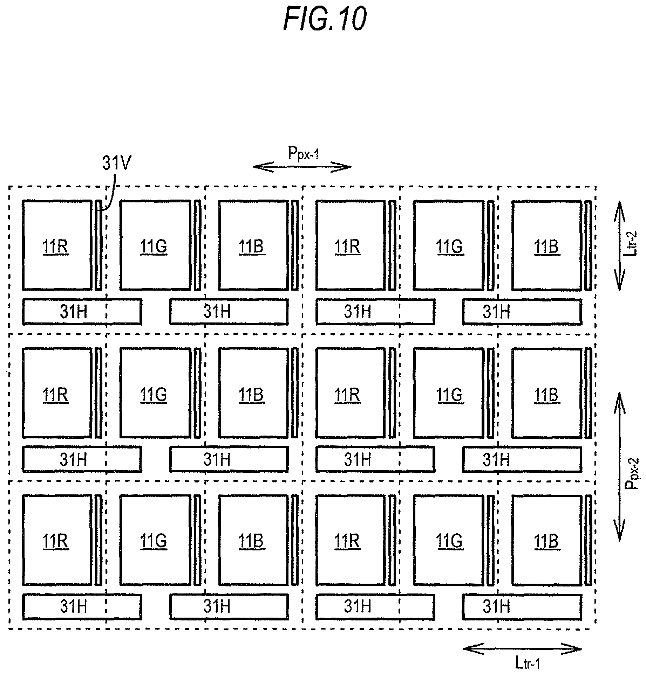

FIGS. 9A and 9B and FIG. 10 exemplify the shapes of the light transmission parts 31. A part of all of the light transmission parts 31 are periodically provided in a first direction (horizontal direction) and a second direction (vertical direction) of the image display part. Here, in the example of FIG. 9A, a light transmission part 31H extending in the first direction (horizontal direction) through the lower part of pixels is provided to extend over one pixel unit including three pixels (11R, 11G, 11B). A light transmission part 31V extending in the second direction (vertical direction) is provided for each of the pixels 11R, 11G and 11B and is provided between a pixel and a pixel. In the example shown in FIG. 9B, a light transmission part 31H and a light transmission part 31V are connected to each other. In the example shown in FIG. 10, although a light transmission part 31H is provided to extend over one pixel unit including three pixels (11R, 11G, 11B), differently from FIG. 9A, the light transmission part 31H includes two portions. When the length of the light transmission part 31 in the first direction is Ltr-1, and the pitch of the pixels 11 in the first direction is Ppx-1, the line aperture ratio Ltr-1/Ppx-1 in the first direction satisfies Ltr-1/Ppx-1 ≥0.5. When the length of the light transmission part 31 in the second direction is Ltr-2, and the pitch of the pixels 11 in the second direction is Ppx-2, the line aperture ratio Ltr-2/Ppx-2 in the second direction satisfies Ltr-2/Ppx-2 ≥0.5. This can be described from the definition of the MTF.

As indicated by the following expression (6) deduced from the expression (2) and the expression (3), the MTF is obtained by squaring the diffraction distribution obtained from the two-dimensional pattern Pat (x, y) on the xy plane of the light transmission part 31, by performing fast Fourier transform of the result of squaring, and further by squaring the result thereof.

$$\mathrm{MTF(fx,fy)} = \left| \mathrm{FFT} \left[ \left| \mathrm{Pdiff(kx,ky)} \right|^2 \right] \right|^2 \quad (6)$$

From the so-called Wiener-Kinchin theorem, Fourier transform of an auto-correlation function is equal to a power spectrum. Thus, the MTF is equal to the square of the absolute value of the auto-correlation function of the diffraction distribution generated in the light transmission part 31. A condition under which there is no point where the auto-correlation function is uncorrelated in the space-frequency region (that is, 0 at the point) is

$$\mathrm{Ltr\text{-}1/Ppx\text{-}1} \geq 0.5$$

$$\mathrm{Ltr\text{-}2/Ppx\text{-}2} \geq 0.5.$$

When the MTF does not have a point of 0, since the expression (5) does not have a singular point, the reproduction of the original image becomes easy. Therefore, it is preferable to satisfy the request that the value of the line aperture ratio Ltr-1/Ppx-1 in the first direction and the value of the line aperture ratio Ltr-2/Ppx-2 in the second direction are 0.5 or more.

[Embodiment 3]

An embodiment 3 is a modification of the embodiment 2, and relates to the second configuration of the invention. As described in the embodiment 2, the expression (1) to obtain the diffraction distribution Pdiff(kx,ky) on the xy plane of the light transmission part 31 includes the wavelength λ of the incident light (external light). Accordingly, when the wavelength distribution of the external light is measured, the MTF of each wavelength can be adapted to an external environment, the correction and compensation of the diffraction can be more accurately performed, and a higher quality pickup image can be obtained.

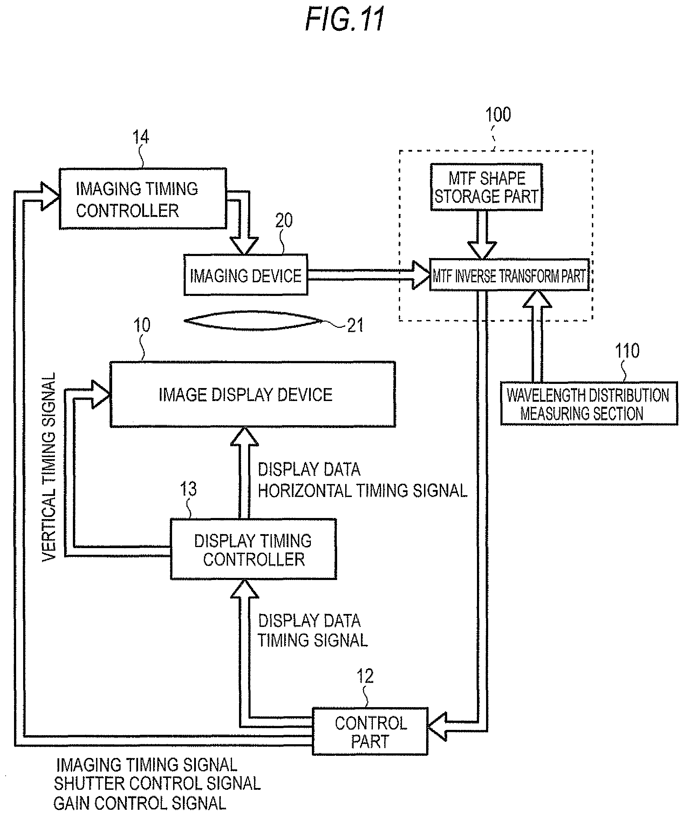

FIG. 11 is a block diagram of an image display device having an imaging device of the embodiment 3. In the embodiment 3, a wavelength distribution measuring section 110 configured to measure a wavelength distribution of external light is further provided. Specifically, the wavelength distribution measuring section 110 includes a set of a photosensor attached with a red filter, a photosensor attached with a green filter, and a photosensor attached with a blue filter. The wavelength distribution (light spectrum) of the external light can be obtained by providing the wavelength distribution measuring section 110 as stated above. The wavelength distribution of each of the original colors (red, green, blue) of a pickup image can be obtained by multiplying the obtained wavelength distribution of the external light and the light spectrum of the imaging device. When the image subjected to the MTF inverse transform process for each wavelength is weighted by the wavelength distribution of the pickup image, the correction and compensation of the diffraction can be performed more accurately.

In the embodiment 3, by adopting the configuration as stated above, not only the correction and compensation can be performed on the diffraction more accurately, but also the accuracy of the image information and image data acquired through the imaging device 20 can be improved (for example, the accuracy of color information is improved). Incidentally, when a blur due to the diffraction is small, it is not necessary to process the pickup image to correct (compensate) the diffraction. However, also in such case, when the wavelength distribution measuring section 110 configured to measure the wavelength distribution of the external light is provided, the accuracy of the image information and image data acquired through the imaging device 20 can be improved.

[Embodiment 4]

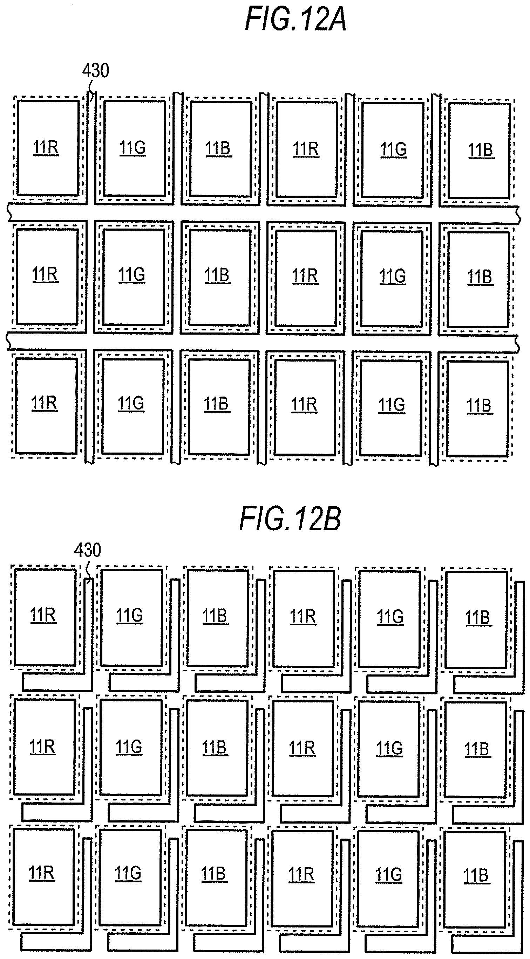

An embodiment 4 relates to the image display device having the imaging device of the second mode of the invention. FIG. 12A or 12B schematically show the arrangement of plural pixels 11 (11R, 11G, 11B) constituting an image display part in the image display device having the imaging device of the embodiment 4. The image display device having the imaging device of the embodiment 4 includes (A) an image display part 10 in which plural pixels 11 (11R, 11G, 11B) including light-emitting devices are arranged, (B) plural light transmission regions 430 provided around at least one pixel 11, (C) an imaging device 20 arranged on the back side of the image display part 10, (D) a light condensing section 21 configured to condense light passing through the light transmission region 430 to the imaging device 20, and (E) a position detecting section 71 configured to obtain position information of a subject based on image information acquired through the imaging device 20.

In the example shown in FIG. 12A, the light transmission region 430 is provided in the entire periphery of the pixel 11, and has a curb shape. In the example shown in FIG. 12B, the light transmission region 430 is provided in a part of the periphery of the pixel 11, and has an "L" shape. In the image display device having the imaging device of the embodiment 4, the light transmission regions 430 are provided around at least one pixel 11, and are specifically provided around $6 \times 3 = 18$ pixels 11.

Except for the above point, the image display device having the imaging device can be made to have the same configuration as that of the image display device having the imaging device of the embodiment 1 to the embodiment 3, and accordingly, its detailed description is omitted.

As described above, in the image display device having the imaging device of the embodiment 4, light passing through the light transmission regions 430 provided around at least one pixel 11 is condensed to the imaging device 20. Accordingly, a highly accurate microlens is not required to accurately focus an image on the imaging device 20, the manufacturing cost of the image display device having the imaging device is not increased, and a sufficient amount of light can be condensed to the imaging device 20. Besides, since the face and eye of the user, the movement of a hand, the peripheral luminance and the like can also be known from the pickup image, various information is obtained from the image display device having the imaging device, and can be sent to various systems. Thus, the added value of the image display device having the imaging device can be raised.

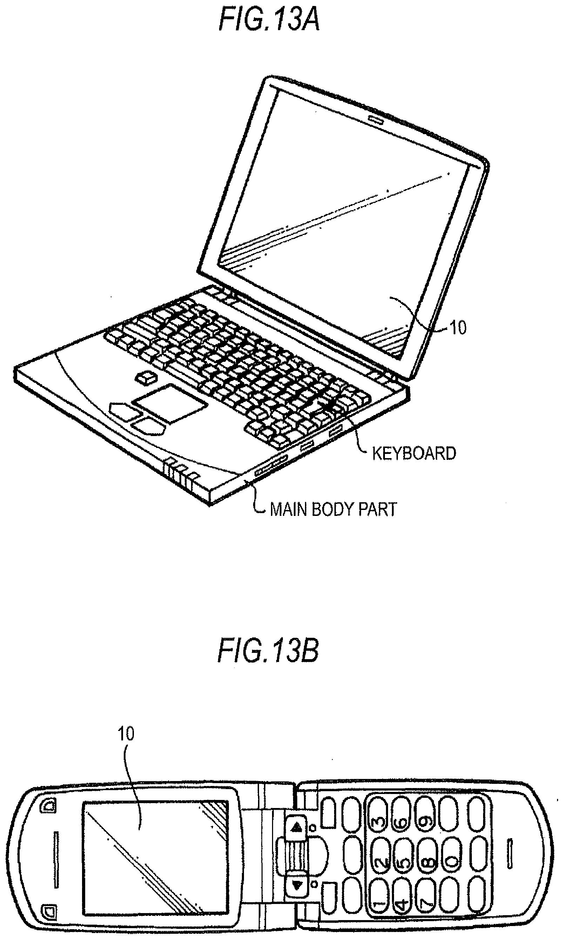

Although the invention is described based on the preferred embodiments, the invention is not limited to these embodiments. The structure and configuration of the image display device having the imaging device described in the embodiment are exemplary, and can be suitably modified. The image display device having the imaging device according to the invention can be used as a substitution of a monitor device assembled in a notebook-size personal computer (see FIG. 13A), and can be used as a substitution of a monitor device assembled in a cellular phone (see FIG. 13B), a PDA or a game machine, or as a substitution of a related art television receiver.

Besides, when plural (for example, two) imaging devices are arranged on the back side of the image display part, not only the position and movement of the subject can be accurately grasped, but also the distance from the image display part to the subject can be accurately measured based on the image information from the imaging device. Alternatively, one pixel unit can be constructed of four or more kinds of pixels, for example, three types of pixels 11R, 11G and 11B, and a pixel to emit while light for improving luminance, a pixel to emit complementary color for expanding a color reproduction range, a pixel to emit yellow for expanding the color reproduction range, a pixel to emit yellow and cyan for expanding the color reproduction range, or the like. According to circumstances, the position detecting section obtains the shape of the subject (for example, the shape expressed by the shape of the body or hand, the shape expressed by a combination of fingers, gesture, etc.) from the position information of the subject by well-known algorithm or software, and various processes corresponding to the shape of the subject may be performed.

Besides, the image display device having the imaging device according to the invention may further include an information transmission section configured to transmit image data acquired through the imaging device 20 and to be displayed on the image display part 10, and a display section configured to display an image, which is based on image data inputted from the outside and to be displayed on the image display part 10, on the image display part 10. The information transmission section transmits the image data acquired through the imaging device 20 and to be displayed on the image display part 10 to the outside, and the display section displays the image, which is based on the image data inputted from the outside and to be displayed on the image display part 10, on the image display part 10. When plural (two or more) image display devices having imaging devices as stated above are connected through a communication line or a network, the so-called video teleconference system (television telephone apparatus) can be configured.

Here, for example, a well-known section used in the video teleconference system (television telephone apparatus) may be used as the information transmission section configured to transmit the image data acquired through the imaging device 20 and to be displayed on the image display part 10, and the display section configured to display the image based on the image data, which is inputted from the outside and is to be displayed on the image display part 10, on the image display part 10. It is preferable to arrange an operation switch, a button, a keyboard and the like on the image display device (image display part) having the imaging device. According to circumstances, the information transmission section and the display section can be constructed of the personal computer provided in the image display device having the imaging device. In this case, the personal computer has only to be connected to a communication line or a network. Besides, the information transmission section and the display section may be assembled in, for example, the control section 12. The so-called video teleconference system (television telephone apparatus) can be configured by connecting plural such image display devices having imaging devices through the communication line or the network. Since the imaging device is arranged on the back side of the image display part, the face of the user positioned in front of the image display part can be photographed, and the face of the user on the partner side displayed on the image display part is directed to this side. Thus, an uncomfortable feeling that their eyes do not meet as in the related art TV telephone system is not given.

When the light transmission region includes plural light transmission parts, and each of the light transmission parts is provided for a pixel, in order to suppress the occurrence of the diffraction phenomenon in the light transmission parts constituting the light transmission region, in the respective embodiments, at least one of the following three forms may be adopted.

(Case-A) The sizes of the plural light transmission parts are made random.
(Case-B) The shapes of the plural light transmission parts are random
(Case-C) The arrangement pitches of the plural light transmission parts are made random.

That is, the (Case-A) may be separately adopted, the (Case-B) may be separately adopted, the (Case-C) may be separately adopted, the (Case-A) and the (Case-B) may be combined and adopted, the (Case-A) and the (Case-C) may be combined and adopted, the (Case-B) and the (Case-C) may be combined and adopted, or the (Case-A), the (Case-B) and the (Case-C) may be combined and adopted. Further, the combination with the diffraction correcting section 100 described in the embodiment 2 may be adopted. The minimum value of the size or the minimum shape of the light transmission part depends on the minimum working size (for example, 0.5 $\mu$m) in the photolithography technique or etching technique for providing the light transmission part.

Incidentally, when the sizes of the plural light transmission parts are made random, specifically, it is preferable that the sizes of at least two light transmission parts (for convenience, called "light transmission part B, light transmission part C") adjacent to one light transmission part (for convenience, called "light transmission part A"), preferably, two light transmission parts arranged in the horizontal direction, more preferably, three light transmission parts (for convenience, called "light transmission part B, light transmission part C, light transmission part D") adjacent to the light transmission part A, more preferably, four light transmission parts (for convenience, called "light transmission part B, light transmission part C, light transmission part D, light transmission part E") adjacent to the light transmission part A are made different from each other. That is, the sizes of the light transmission part A and the light transmission part B are made different from each other, the sizes of the light transmission part A and the light transmission part C are made different from each other, the sizes of the light transmission part A and the light transmission part D are made different from each other, and the sizes of the light transmission part A and the light transmission part E are made different from each other. Similarly, the shapes of the plural light transmission parts are made random. Specifically, it is preferable that the shapes of at least two light transmission parts (light transmission part B, light transmission part C) adjacent to one light transmission part (light transmission part A), preferably, two light transmission parts arranged in the horizontal direction, more preferably, three light transmission parts (light transmission part B, light transmission part C, light transmission part D) adjacent to the light transmission part A, more preferably, four light transmission parts (light transmission part B, light transmission part C, light transmission part D, light transmission part E) adjacent to the light transmission part A are made different from each other. That is, the shapes of the light transmission part A and the light transmission part B are made different from each other, the shapes of the light transmission part A and the light transmission part C are made different from each other, the shapes of the light transmission part A and the light transmission part D are made different from each other, and the shapes of the light transmission part A and the light transmission part E are made different from each other. Similarly, the arrangement pitches of the plural light transmission parts are made random. Specifically, it is preferable that the arrangement pitches of at least two light transmission parts (light transmission part B, light transmission part C) adjacent to one light transmission part (light transmission part A), preferably, two light transmission parts arranged in the horizontal direction, more preferably, three light transmission parts (light transmission part B, light transmission part C, light transmission part D) adjacent to the light transmission part A, more preferably, four light transmission parts (light transmission part B, light transmission part C, light transmission part D, light transmission part E) adjacent to the light transmission part A are made different from each other. That is, the arrangement pitches of the light transmission part A and the light transmission part B are made different from each other, the arrangement pitches of the light transmission part A and the light transmission part C are made different from each other, the arrangement pitches of the light transmission part A and the light transmission part D are made different from each other, and the arrangement pitches of the light transmission part A and the light transmission part E are made different from each other.

Alternatively, when the light transmission region includes plural light transmission parts, and each of the light transmission parts is provided for a pixel, in order to suppress the occurrence of the diffraction phenomenon in the light transmission parts constituting the light transmission region, in the respective embodiments, the light transmission part may be made to have a double annular structure (double outlined structure). Specifically, such a configuration may be adopted that the light transmission part includes a first light transmission part and a second light transmission part, and the second light transmission part is arranged so as to surround the first light transmission part. The sizes, shapes and arrangement states of the fist light transmission part and the second light transmission part, and the position relation between the first light transmission part and the second light transmission part are optimized, so that it is possible to certainly suppress the occurrence of the diffraction phenomenon. Further, the combination with the diffraction correcting section 100 described in the embodiment 2 may be adopted.

The present application contains subject matter related to those disclosed in Japanese Priority Patent Applications JP 2010-012051 and JP 2010-012052 both filed in the Japan Patent Office on January 22, 2010, It should be understood by those skilled in the art that various modifications, combinations, sub-combinations and alterations may occur depending on design requirements and other factors insofar as they are within the scope of the appended claims.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

## Claims

1.  An image display device having an imaging device, comprising:

    an image display part (10) in which a plurality of pixels (11) including light-emitting devices are arranged;
    a light transmission region (30) provided in the image display part;
    an imaging device (20) arranged on a back side of the image display part;
    a light condensing means (21) for condensing light passing through the light transmission region to the imaging device; and
    a position detecting means (71) for obtaining position information of a subject based on image information acquired through the imaging device; wherein
    the light transmission region is provided around at least one pixel, the light transmission region being provided in a part of the periphery of the pixel along two or more continuous sides among sides corresponding to the boundary of the pixel;
    a part or all of the light transmission parts (31) constituting the light transmission region are periodically provided in a first direction and a second direction of the image display part, and
    when a length of the light transmission part in the first direction is Ltr-1, and a pitch of the pixels in the first direction is Ppx-1, Ltr-1/Ppx-1 $\geq$ 0.5 is satisfied; wherein
    the image display part is adapted to display a three-dimensional image; and
    the position detecting means is adapted to obtain position information of an observer based on image data acquired through the imaging device.

2.  The image display device having the imaging device according to claim 1, wherein the light transmission region is provided for a plurality of pixels.

3.  The image display device having the imaging device according to claim 1, wherein
    when a length of the light transmission part in the second direction is Ltr-2, and a pitch of the pixels in the second direction is Ppx-2, Ltr-2/Ppx-2 $\geq$ 0.5 is satisfied.

4.  The image display device having the imaging device according to claim 1, further comprising a wavelength distribution measuring means for measuring a wavelength distribution of external light.

5.  The image display device having the imaging device according to claim 1, wherein the light-emitting device includes an organic electroluminescence device.

6.  The image display device having the imaging device according to claim 1, wherein
    the image display part includes (a) a first substrate (40), (b) a drive circuit provided on the first substrate, (c) an interlayer insulating layer (41) to cover the drive circuit, (d) a light-emitting part (63) provided on the interlayer insulating layer, (e) a protection layer (64) provided on the light-emitting part, (f) a light-shielding layer (65) provided on the protection layer, and (g) a second substrate (67) to cover the protection layer and the light-shielding layer, each of the pixels includes the drive circuit and the light-emitting part,

the light-shielding layer includes an opening (65A),

the light transmission part constituting the light transmission region includes the opening, a portion of the protection layer positioned below the opening, and a portion of the interlayer insulating layer, and

the light condensing means and the imaging device are arranged on a side of a surface of the first substrate, which does not face the second substrate.

7. The image display device having the imaging device according to claim 1, wherein

a plurality of the light transmission regions, a plurality of the imaging devices and a plurality of the light condensing means are provided, and

each of the light condensing means condenses light passing through each of the light transmission regions to each of the imaging devices.

8. The image display device having the imaging device according to claim 7, wherein the position detecting means obtains the position information of the observer based on the image data obtained through the plurality of the imaging devices.

9. The image display device having the imaging device according to claim 1, wherein the position information of the observer is distance data from the image display part to the observer.

10. The image display device having the imaging device according to claim 1, wherein the position information of the observer is obtained base on both eyes of the observer of the image data photographed through the plurality of the imaging devices.

## Patentansprüche

1. Bildanzeigevorrichtung, die eine Abbildungsvorrichtung aufweist, die aufweist:

einen Bildanzeigeteil (110), in dem eine Vielzahl von Bildpunkten (11), die lichtausstrahlende Vorrichtungen aufweisen, angeordnet sind;

ein Lichtübergangsgebiet (30), das im Bildanzeigeteil vorgesehen ist;

eine Abbildungsvorrichtung (20), die an einer Rückseite des Bildanzeigeteils angeordnet ist;

ein Lichtbündelungsmittel (21), um Licht zu bündeln, das durch das Lichtübertragungsgebiet zur Abbildungsvorrichtung verläuft; und

ein Positionserkennungsmittel (71), um Positionsinformationen eines Subjekts basierend auf Bildinformationen zu erhalten, die über die Abbildungsvorrichtung erfasst wurden; wobei

das Lichtübertragungsgebiet um wenigstens einen Bildpunkt herum vorgesehen ist, wobei das Lichtübertragungsgebiet in einem Teil am Umfang des Bildpunkts entlang von zwei oder mehreren fortlaufenden Seiten aus Seiten vorgesehen ist, die der Begrenzung des Bildpunkts entsprechen;

ein Teil oder alle von den Lichtübertragungsteilen (31), die das Lichtübertragungsgebiet bilden, in regelmäßigen Abständen in einer ersten Richtung und einer zweiten Richtung des Bildanzeigeteils vorgesehen sind, und wenn eine Länge des Lichtübertragungsteils in der ersten Richtung Ltr-1 beträgt, und ein Abstand der Bildpunkte in der ersten Richtung Ppx-1, ist Ltr-1/Ppx-1 $\geq$ 0,5 erfüllt;

wobei der Bildanzeigeteil dazu ausgelegt ist, ein dreidimensionales Bild anzuzeigen; und

das Positionserkennungsmittel dazu ausgelegt ist, Positionsinformationen eines Beobachters basierend auf den über die Abbildungsvorrichtung erfassten Bilddaten zu erhalten.

2. Bildanzeigevorrichtung, die die Abbildungsvorrichtung aufweist, nach Anspruch 1, wobei das Lichtübertragungsgebiet für eine Vielzahl von Bildpunkten vorgesehen ist.

3. Bildanzeigevorrichtung, die die Abbildungsvorrichtung aufweist, nach Anspruch 1, wobei wenn eine Länge des Lichtübertragungsteils in der zweiten Richtung Ltr-2 ist und ein Abstand der Bildpunkte in der zweiten Richtung Ppx-2 ist, Ltr-2/Ppx-2 $\geq$ 0,5 erfüllt ist.

**4.** Bildanzeigevorrichtung, die die Abbildungsvorrichtung aufweist, nach Anspruch 1, die weiterhin ein Mittel zum Messen der Wellenlängenverteilung aufweist, um eine Wellenlängenverteilung des externen Lichts zu messen.

**5.** Bildanzeigevorrichtung, die die Abbildungsvorrichtung aufweist, nach Anspruch 1, wobei die Lichtausstrahlungseinheit eine organische Elektroluminiszenzvorrichtung aufweist.

**6.** Bildanzeigevorrichtung, die die Abbildungsvorrichtung aufweist, nach Anspruch 1, wobei
der Bildanzeigeteil aufweist (a) ein erstes Substrat (40), (b) einen auf dem ersten Substrat vorgesehenen Steuerschaltkreis, (c) eine Isolierungszwischenschicht (41) zum Abdecken des Steuerschaltkreises, (d) einen an der isolierenden Zwischenschicht vorgesehenen Licht ausstrahlenden Teil (63), (e) eine auf dem Licht ausstrahlenden Teil vorgesehene Schutzschicht (64), (f) eine auf der Schutzschicht vorgesehene Lichtabschirmungsschicht (65) und (g) ein zweites Substrat (67), um die Schutzschicht und die Lichtabschirmungsschicht abzudecken,
wobei ein jeder der Bildpunkte den Steuerschaltkreis und das lichtausstrahlende Teil aufweist,
die Lichtabschirmungsschicht eine Öffnung (65A) aufweist, das Lichtübertragungsteil, das das Lichtübertragungsgebiet bildet, eine Öffnung, einen Bereich der Schutzschicht, der unter der Öffnung angeordnet ist, und einen Bereich der isolierenden Zwischenschicht aufweist, und
das Lichtbündelungsmittel und die Abbildungsvorrichtung an einer Seite einer Fläche des ersten Substrats angeordnet sind, die dem zweiten Substrat nicht zugewandt ist.

**7.** Bildanzeigevorrichtung, die die Abbildungsvorrichtung aufweist, nach Anspruch 1, wobei
eine Vielzahl der Lichtübertragungsgebiete, eine Vielzahl der Abbildungsvorrichtungen und eine Vielzahl der Lichtbündelungsmittel vorgesehen sind, und
ein jedes der Lichtbündelungsmittel Licht bündelt, das durch ein jedes der Lichtübertragungsgebiete zu einer jeden der Abbildungsvorrichtungen verläuft.

**8.** Bildanzeigevorrichtung, die die Abbildungsvorrichtung aufweist, nach Anspruch 7, wobei das Positionserkennungsmittel die Positionsinformationen des Beobachters basierend auf den Bilddaten erhält, die über die Vielzahl der Abbildungsvorrichtungen erhalten wurden.

**9.** Bildanzeigevorrichtung, die die Abbildungsvorrichtung aufweist, nach Anspruch 1, wobei die Positionsinformationen des Beobachters Abstandsdaten von dem Bildanzeigeteil zum Beobachter sind.

**10.** Bildanzeigevorrichtung, die die Abbildungsvorrichtung aufweist, nach Anspruch 1, wobei die Positionsinformationen des Beobachters basierend auf beiden Augen des Beobachters erhalten werden, die über die Vielzahl der Abbildungsvorrichtungen fotografiert wurden.

**Revendications**

**1.** Dispositif d'affichage d'image ayant un dispositif d'imagerie, comprenant :

une partie d'affichage d'image (10) dans laquelle une pluralité de pixels (11) comprenant des dispositifs émetteurs de lumière sont disposés ;
une région de transmission de lumière (30) pourvue dans la partie d'affichage d'image ;
un dispositif d'imagerie (20) disposé sur une face arrière de la partie d'affichage d'image ;
un moyen de condensation de lumière (21) pour condenser la lumière passant par la région de transmission de lumière vers le dispositif d'imagerie ; et
un moyen de détection de position (71) pour obtenir des informations de position d'un sujet sur la base d'informations d'image acquises par le dispositif d'imagerie ; où
la région de transmission de lumière est pourvue autour d'au moins un pixel, la région de transmission de lumière étant pourvue dans une partie de la périphérie du pixel le long de deux, ou davantage, côtés continus parmi les côtés correspondant à la limite du pixel ;
une partie ou la totalité des parties de transmission de lumière (31) constituant la région de transmission de lumière sont périodiquement pourvues dans une première direction et une seconde direction de la partie d'affichage d'image, et
lorsqu'une longueur de la partie de transmission de lumière dans la première direction est Ltr-1, et un pas des pixels dans la première direction est Ppx-1, l'inégalité Ltr-1/Ppx-1 $\geq$ 0,5 est satisfaite ; où
la partie d'affichage d'image est adaptée pour afficher une image tridimensionnelle ; et

le moyen de détection de position est adapté pour obtenir des informations de position d'un observateur sur la base de données d'image acquises par le dispositif d'imagerie.

2. Dispositif d'affichage d'image ayant le dispositif d'imagerie selon la revendication 1, dans lequel la région de transmission de lumière est pourvue pour une pluralité de pixels.

3. Dispositif d'affichage d'image ayant le dispositif d'imagerie selon la revendication 1, dans lequel :
lorsqu'une longueur de la partie de transmission de lumière dans la seconde direction est Ltr-2, et un pas des pixels dans la seconde direction est Ppx-2, alors l'inégalité Ltr-2/Ppx-2 $\geq$ 0,5 est satisfaite.

4. Dispositif d'affichage d'image ayant le dispositif d'imagerie selon la revendication 1, comprenant en outre un moyen de mesure de distribution de longueur d'onde pour mesurer une distribution de longueur d'onde de lumière externe.

5. Dispositif d'affichage d'image ayant le dispositif d'imagerie selon la revendication 1, dans lequel le dispositif émetteur de lumière comprend un dispositif électroluminescent organique.

6. Dispositif d'affichage d'image ayant le dispositif d'imagerie selon la revendication 1, dans lequel :

la partie d'affichage d'image comprend (a) un premier substrat (40), (b) un circuit de commande pourvu sur le premier substrat, (c) une couche isolante intercouche (41) pour couvrir le circuit de commande, (d) une partie émettrice de lumière (63) pourvue sur la couche isolante intercouche, (e) une couche de protection (64) pourvue sur la partie émettrice de lumière, (f) une couche de protection contre la lumière (65) pourvue sur la couche de protection et (g) un second substrat (67) pour couvrir la couche de protection et la couche de protection contre la lumière,
chacun des pixels comprend le circuit de commande et la partie émettrice de lumière,
la couche de protection contre la lumière comprend une ouverture (65A),
la partie de transmission de lumière constituant la région de transmission de lumière comprend l'ouverture, une partie de la couche de protection positionnée sous l'ouverture et une partie de la couche isolante intercouche, et
le moyen de condensation de lumière et le dispositif d'imagerie sont disposés sur un côté d'une surface du premier substrat, qui ne fait pas face au second substrat.

7. Dispositif d'affichage d'image ayant le dispositif d'imagerie selon la revendication 1, dans lequel :

une pluralité des régions de transmission de lumière, une pluralité des dispositifs d'imagerie et une pluralité des moyens de condensation de lumière sont pourvus, et
chacun des moyens de condensation de lumière condense la lumière passant par chacune des régions de transmission de lumière vers chacun des dispositifs d'imagerie.

8. Dispositif d'affichage d'image ayant le dispositif d'imagerie selon la revendication 7, dans lequel le moyen de détection de position obtient les informations de position de l'observateur sur la base des données d'image obtenues par la pluralité des dispositifs d'imagerie.

9. Dispositif d'affichage d'image ayant le dispositif d'imagerie selon la revendication 1, dans lequel les informations de position de l'observateur sont des données de distance entre la partie d'affichage d'image et l'observateur.

10. Dispositif d'affichage d'image ayant le dispositif d'imagerie selon la revendication 1, dans lequel les informations de position de l'observateur sont obtenues sur la base des deux yeux de l'observateur des données d'image photographiées par la pluralité des dispositifs d'imagerie.

## FIG.1A

10
20
30

## FIG.1B

10
20
21
30
73
70
72
PERSONAL COMPUTER
POSITION DETECTING SECTION — 71

## FIG.1C

| 11R | 11G | 11B | 11R | 11G | 11B |
|-----|-----|-----|-----|-----|-----|
| 31  | 31  | 31  | 31  | 31  | 31  |
| 11R | 11G | 11B | 11R | 11G | 11B |
| 31  | 31  | 31  | 31  | 31  | 31  |
| 11R | 11G | 11B | 11R | 11G | 11B |
| 31  | 31  | 31  | 31  | 31  | 31  |

## FIG.2

| 21 | LIGHT CONDENSING SECTION |
| 20 | IMAGING DEVICE |

## FIG.3A

20
21
10
30

USER

USER DISPLAYED
ON IMAGE DISPLAY
DEVICE

## FIG.3B

IMAGING DEVICE

IMAGE DISPLAY PART

USER

USER DISPLAYED
ON IMAGE DISPLAY
DEVICE

## FIG.4A

## FIG.4B

PERSONAL COMPUTER

POSITION DETECTING SECTION

## FIG.4C

## FIG.5

# FIG.6

## FIG.7A

## FIG.7B

# FIG.8

100

14

IMAGING TIMING
CONTROLLER

MTF SHAPE
STORAGE PART

20

IMAGING DEVICE

MTF INVERSE
TRANSFORM PART

21

10

IMAGE DISPLAY DEVICE

VERTICAL TIMING SIGNAL

DISPLAY DATA
HORIZONTAL TIMING SIGNAL

13

DISPLAY TIMING
CONTROLLER

DISPLAY DATA
TIMING SIGNAL

12

CONTROL PART

IMAGING TIMING SIGNAL
SHUTTER CONTROL SIGNAL
GAIN CONTROL SIGNAL

## FIG.9A

## FIG.9B

# FIG.10

# FIG.11

IMAGING TIMING SIGNAL
SHUTTER CONTROL SIGNAL
GAIN CONTROL SIGNAL

## FIG.12A

430

| 11R | 11G | 11B | 11R | 11G | 11B |
|-----|-----|-----|-----|-----|-----|
| 11R | 11G | 11B | 11R | 11G | 11B |
| 11R | 11G | 11B | 11R | 11G | 11B |

## FIG.12B

430

| 11R | 11G | 11B | 11R | 11G | 11B |
|-----|-----|-----|-----|-----|-----|
| 11R | 11G | 11B | 11R | 11G | 11B |
| 11R | 11G | 11B | 11R | 11G | 11B |

## FIG.13A

10

KEYBOARD

MAIN BODY PART

## FIG.13B

10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005176151 A
- JP 2005010407 A
- US 20080106629 A
- US 6454414 B
- JP 2000341591 A
- GB 2324428 A
- JP 2044995 A
- JP 2010012051 A
- JP 2010012052 A